# EUROPEAN PATENT APPLICATION

(11) **EP 1 160 215 A1**
(43) Date of publication of application: **05.12.2001**
(21) Application number: 01304081.1
(22) Date of filing: 04.05.2001
(51) Int. Cl.: C03C 17/40, C04B 41/90

(54) **Simplified gold vacuum vapor deposition**

(30) Priority: 11.05.2000 US 569173
(71) Applicant: GENERAL ELECTRIC COMPANY, Schenectady, NY 12345 (US)
(72) Inventor: Golz, Thomas Michael, Willoughby Hills, Ohio 44094 (US)
(74) Representative: Goode, Ian Roy

(57) **Abstract**

The invention pertains to a simplified vacuum vapor deposition process for applying adherent gold coatings to an inorganic insulating substrate such as glass. More particularly, a base layer is deposited on the substrate prior to the initiation of the deposition of the gold layer. The depositions of the base layer and gold layer are timed so that the first of the gold layer atoms are deposited simultaneously with the last of the still active base layer atoms, thus preventing the formation on the base layer of an oxide layer or water layer, either of which limit the adhesion of the gold layer.

## Description

This invention pertains to a simplified vacuum vapor deposition process for applying adherent gold coatings to an inorganic insulating substrate such as glass. More particularly, the invention relates to a vacuum vapor deposition process wherein the deposition of the base layer atoms and gold layer atoms is timed so that the first of the gold layer atoms are deposited simultaneously with the last of the still active base layer atoms.

Vacuum deposition of materials is used in processes such as the formation of electrical devices (e.g., thin film resistors and capacitors), semiconductor devices (e.g., integrated circuits), optical interference film, reflective surfaces and the manufacture of devices with decorative or utilitarian metal patterns. Typically these processes are carried out by heating the source material within a vacuum chamber or bell jar so that a vapor stream of the material is created which subsequently condenses on surfaces within the chamber.

Referring particularly to the vacuum vapor deposition of gold, gold does not conventionally adhere to most materials, particularly ceramic or glass materials. In this regard, it tends to form small microspheres that wipe off easily. In the past, the adhesion of vacuum vapor deposited gold has been increased by the application of an underlayer material such as titanium or chromium. The use of titanium or chromium in the deposition process, however, has itself been problematic. For example, these underlayer materials are very reactive and within seconds of deposition begin to pull water out of the typical 10⁻⁵ torr residual gas in a chamber, which due to outgassing contains a significant amount of water. Accordingly, gold does not adhere satisfactorily to the underlayer material. To solve this problem, various solutions have been implemented in the past, including glow discharge, sputtering, and use of a cleaner vacuum. These solutions are problematic in that they are both expensive and further complicate the process.

Thus, there presently exists a need for a simplified and inexpensive vacuum vapor deposition process wherein gold deposited on an inorganic insulating substrate such as glass adheres satisfactorily to the substrate material.

According to an exemplary embodiment of the invention, a process for forming an adherent metal layer on an inorganic insulating substrate comprises the steps of: depositing a base layer on the inorganic insulating substrate; and depositing the metal layer on the base layer, the metal layer deposited so that the first of the metal layer atoms are deposited simultaneously with the last of the still active base layer atoms. In the preferred embodiment the metal layer is pure gold and the base layer is pure titanium.

A principal advantage of the invention is provided by a simplified gold vacuum vapor deposition process which provides excellent adhesion to inorganic insulating materials such as glass.

Still another advantage of the present invention is that the gold vacuum vapor deposition process prevents the formation on the base layer of an oxide or water layer, which limits adhesion of the gold layer.

Still another advantage of the invention is that an adherent gold layer is formed by vacuum vapor deposition on a nonconductive substrate without the need for aggressive alkaline or ultrasonic cleaning processes.

Still another advantage of the invention is that an inexpensive vacuum system is disclosed which results in improved adhesion of gold to a nonconductive substrate.

Still a further advantage of the invention is that the deposited gold layer forms a interlocking amalgamate with a deposited base layer.

An embodiment of the invention will now be described, by way of example, with reference to the accompanying drawings, in which:
FIG. 1 is a schematic representation of a four-coil system suitable for practicing the gold coating process of the present invention;
FIG. 2 is an end view of the coil configuration system of FIG. 1;
FIG. 3 is a loaded sphere placed over the coil configuration system of FIG. 1; and
FIG. 4 is a schematic representation of a two-coil system suitable for practicing the gold coating process of the present invention.

The present invention relates to the deposition of an adherent metal coating for an inorganic insulating substrate of any known ceramic or glass materials. Examples of glasses include quartz, borosilicate glasses, soda-lime glasses, and pyrex. Examples of ceramics include alumina, porcelain, silicon monoxide and silicon dioxide. The insulator may also consist of a film of inorganic insulating material such as silicon monoxide, silicon dioxide or silicon nitride as a coating or deposit on a conductive or nonconductive support material such as glass or silicon.

The adherent metals which can be deposited in accordance with the present invention include precious metals such as silver, platinum and gold, but in the preferred embodiment, the metal is gold because of the known difficulties associated with the metallizing of gold.

In the process of the present invention, a base layer is initially deposited, preferably by vacuum vapor deposition, on the inorganic insulating substrate. The base layer is preferably of a thickness of 10-50 nm, and most preferably 20 nm. Suitable examples of materials for use as the base layer include chromium and titanium and any other metal having (1) good adhesion to the substrate; (2) a boiling point less than tungsten melts, but high enough to not be ablated by the gold; and (3) a surface which, when clean, is active enough to provide good adhesion for the gold. In the preferred embodiment, the base layer is pure titanium.

The base layer is deposited by vacuum vapor deposition for a predetermined period of time. Prior to the expiration of that period of time, vacuum vapor deposition of the gold layer is initiated so that the first gold atoms are deposited into and simultaneously with the last of the still active base layer atoms deposited. The process forms not only a clean interface between the deposited gold atoms and base layer atoms, but a thin interlocking amalgamate. This can be confirmed by perpendicular pull tape tests of the type well-known to those skilled in the art.

The vacuum deposition process can be done at pressures of 10⁻⁴ torr or greater. Because the process can be implemented using a simple tungsten coil vapor deposition system it can also be incorporated on multi-shot rotary equipment with times consistent with aluminizing , using heated but not super clean glass - that is, glass as pressed without alkali or ultrasonic washing.

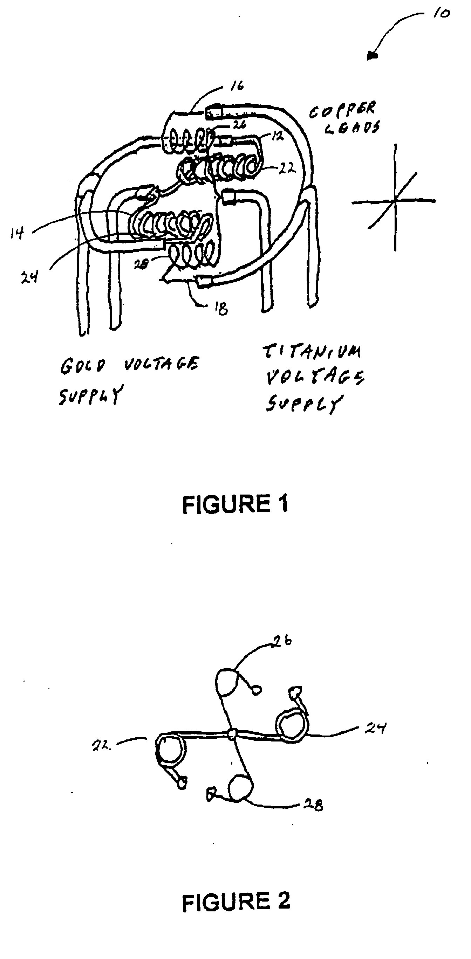

FIG. 1 is a schematized representation of a four-coil system **10** which can be used to form the gold coating of the present invention. The coil configuration **10** includes resistive filament structures **12, 14, 16, 18,** typically of tungsten and having coils **22**, **24**, **26**, **28** which develop high temperature resistance heating upon passage of electric current therethrough from two power supplies (not shown).

The coil configuration **10** includes two sets of parallel coils **22**, **24**, **26**, **28** as is best illustrated in FIG. 2. Coils **22**, **24** are used for the deposition of the gold metal. Coils **26**, **28** are used for the deposition of the titanium metal. During operation, wires of material to be deposited such as titanium and gold are inserted in the heating coils **22**, **24**, **26**, **28** and power is supplied to heat the wires under vacuum conditions. Vacuum conditions are created using a bell jar of a construction well-known to those of ordinary skill in the art.

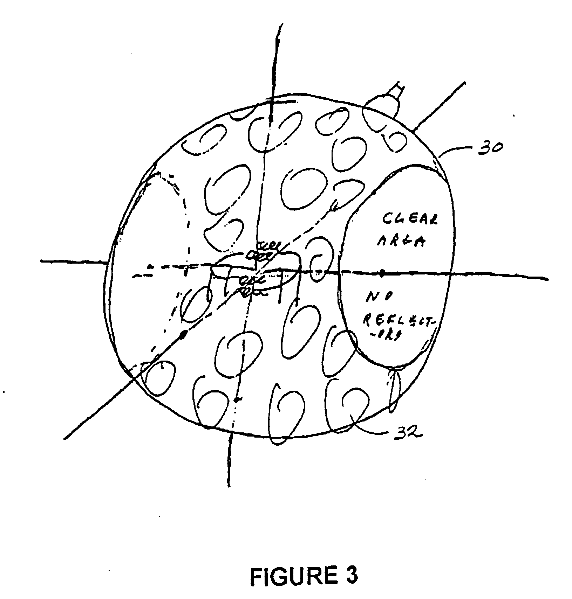

Referring to FIG. 3, a sphere **30** loaded with multiple glass reflectors **32** is placed over the coil configuration system **10.** A bell jar (not shown) is used to put the system under vacuum (preferably 10⁻⁴ torr) using techniques well-known to those skilled in the art.

Preferably the titanium base layer is deposited at a thickness of 10 nm to 50 nm angstroms followed by the deposition of a gold layer of a thickness required by the particular application. The two-step process must be implemented without breaking chamber vacuum (i.e., in an essentially continuous process) by inserting gold wires in two filament coil arrays **22**, **24** and titanium wire in the filament coil arrays **26**, **28**, then sequentially heating the titanium-containing and gold-containing filament arrays **22**, **24** and **26**, **28** for the time required to deposit the desired thickness of material.

As is understood by one of ordinary skill in the art, the particular timing pertaining to the deposition of the titanium and gold is dependent on the specific coating coil configuration used. More particularly, as understood by the ordinarily skilled artisan, the time is dependent upon certain parameters starting with the distance from the coils to the piece. Distance and desired thickness sets slug mass, which determines coil mass and design, which sets coil voltage for proper deposition rate, which then determines time.

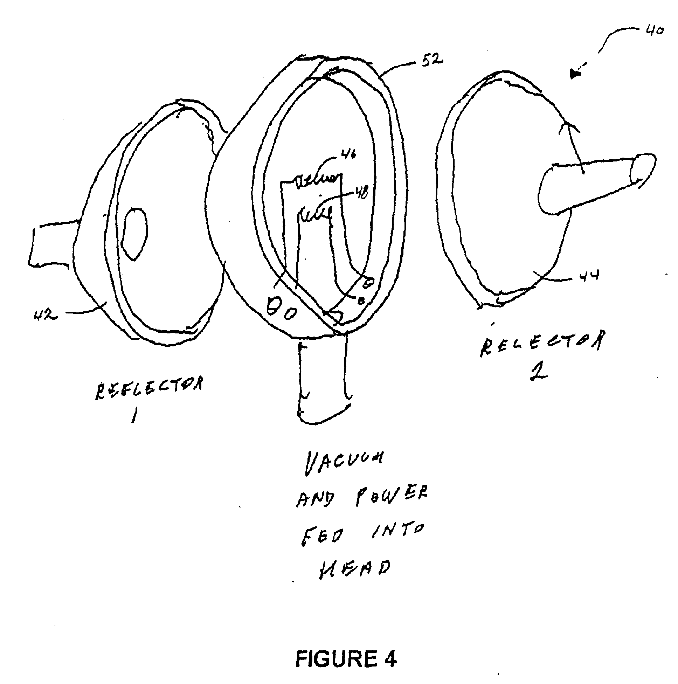

FIG. 4 illustrates a two-coil system **40** useful in the process of the present invention. The base layer and gold layer are deposited on the reflectors **42**, **44** by vacuum vapor deposition. Coil **46** is used for the deposition of the base layer and coil **48** is used for the deposition of the gold layer. Vacuum and power feeds (not shown) are fed into the head **52** of the system **40**. As is understood by one of ordinary skill in the art, many variations of the two-coil system **40** and four-coil system **10** or other multi-coil systems can be used in the practice of the present invention. Most importantly, in accordance with the process of the present invention, the respective depositions of the base metal layer and gold metal layer are timed so that the deposition of gold layer atoms overlaps, in part, with the deposition of the base layer atoms. More particularly, the base layer is deposited for a predetermined interval of time. Prior to deposition of the last base layer atoms, deposition of the gold layer is initiated such that the first gold atoms are deposited down into and simultaneously with the last of the still active base layer atoms. By "still active" it is meant the atoms have not formed a bond with oxygen or water from the residual gas in the deposition chamber.

The present invention may be implemented using instantaneous switching of power from titanium coil arrays **22**, **24** to gold coil arrays **26**, **28** relying on thermal mass to continue the base layer deposition while the gold coils heat up. However, any decrease in the rate of base layer atoms impinging on the substrate increases the likelihood of interlayer oxides or water and hence can decrease the adhesion of the gold layer.

The process of the present invention is illustrated in the following example.

### EXAMPLE

A 7 inch aluminum sphere punched and fixtured to hold 27 MR16 glass reflectors was loaded in a 12 inch bell jar having four heater coils at the sphere center - two for titanium and two for gold. The glass-reflectors were taken out of the box, as pressed, and heated to 120°C on the fixture prior to loading in the bell jar. The heater coils were arranged so that each reflector sees at least one coil of titanium and one of gold. No effort was taken to shield the coils from each other.

Each titanium sliver was .007 gram and about 10 mm in length. The gold piece was .26 gram, .008 inch thick by .12 inch wide cut to 22 mm in length from a ribbon, then rippled. The coils for the titanium were .9 gram, 5½ turn, three strand of a 5 mm inner diameter. The coils for the gold were 4.9 grams, 6½ turn three strand with a 5 mm inner diameter. The titanium deposition time/volts were 5 seconds at 14V. The gold deposition time/volts were 14 seconds at 13V. The vacuum created in the bell jar during deposition was 3 X 10⁻⁴ torr. Using the above-referenced coil system , titanium was deposited in the 5-second interval of time. Gold deposition was initiated approximately 2 seconds prior to the end of the titanium deposition. The overlapping time interval allowed time for the gold coil to heat up to ensure a transition to gold deposition prior to the deposition of the last still active titanium atoms.

The resultant samples were tested using a standard perpendicular pull tape test. Tape was pressed on the sample and then pulled off perpendicular to the surface. Results indicated no delamination, no gold pulled away by the tape.

The invention has been described with reference to the preferred embodiment. Obviously, modifications and alterations will occur to others upon a reading and understanding of the specification. For example, a wide variety of deposition systems other than the ones disclosed herein could be used to practice the process of the present invention.

## Claims

1. A process for forming an adherent metal layer on an inorganic insulating substrate comprising the steps of:
depositing a base layer on the inorganic insulating substrate; and
depositing the metal layer on the base layer, the metal layer deposited so that the first of the metal atoms are deposited simultaneously with the last of the still active base layer atoms.

2. The process of claim 1 wherein the metal layer comprises gold or other difficult-to-coat metals.

3. A process for depositing an adherent gold layer to a nonconductive substrate comprising the steps of:
depositing a base layer on the nonconductive substrate for a first length of time;
prior to the expiration of the first length of time, initiating the deposition of the gold layer such that the gold layer forms a thin interlocking amalgamate with the base layer, thus preventing the formation of any oxide-containing layer or water-containing layer.

4. The process of any one of claims 1 to 3 wherein the inorganic insulating substrate is a glass material or ceramic material.

5. The process of claim 4 wherein the glass material is selected from the group consisting of quartz, borosilicate glasses, soda-lime glasses and pyrex.

6. The process of claim 4 wherein the ceramic material is selected from the group consisting of alumina, porcelain, silicon monoxide and silicon dioxide.

7. The process of any one of claims 1 to 6 wherein the base layer comprises a material that adheres to the substrate and has an active surface for adhesion of the metal layer.

8. The process of any one of claims 1 to 7 wherein the step of depositing the base layer is carried out by vacuum vapor deposition.

9. The process of any one of claims 1 to 8 wherein the step of depositing the metal coating is carried out by vacuum vapor deposition.

10. The process of any one of claims 1 to 9 wherein the base layer is deposited at a thickness between about 10 nm and about 50 nm.

11. A process for the vacuum vapor deposition of gold on a glass substrate comprising a titanium base layer, the process comprising the step of depositing gold atoms and titanium atoms so that the first of the gold atoms are deposited simultaneously with the last of the still active titanium atoms.

12. The process of claim 11 wherein the titanium base layer is pure titanium and the gold is pure gold.

13. The process of claim 11 wherein the titanium base layer is substantially free of an oxide layer or water surface layer.
